# EUROPEAN PATENT SPECIFICATION

(11) **EP 2 819 555 B1**
(45) Date of publication and mention of the grant of the patent: **03.05.2017**
(21) Application number: 12869606.9
(22) Date of filing: 01.08.2012
(51) Int. Cl.: A47G 19/22, B32B 37/22, H01L 31/049, B32B 15/20, B32B 27/28

(54) **CONTINUOUS EDGE PROTECTED BARRIER ASSEMBLIES**
SPERRANORDNUNG MIT DURCHGEHENDEM KANTENSCHUTZ
ENSEMBLES BARRIÈRES PROTÉGÉS PAR UN BORD CONTINU

(30) Priority: 01.03.2012 US 201261605496 P
(43) Date of publication of application: 07.01.2015
(73) Proprietor: 3M Innovative Properties Company, St. Paul, MN 55133-3427 (US)
(72) Inventor: WEIGEL, Mark D., Saint Paul, Minnesota 55133-3427 (US); DELMORE, Michael D., Saint Paul, Minnesota 55133-3427 (US); BRUNNER, Dennis M., Saint Paul, Minnesota 55133-3427 (US); RUFF, Andrew T., Saint Paul, Minnesota 55133-3427 (US)
(74) Representative: Vossius & Partner Patentanwälte Rechtsanwälte mbB
(86) International application number: PCT/US2012/049147
(87) International publication number: WO 2013/130122

(56) References cited:
- WO-A2-2009/086095
- US-A1- 2002 012 761
- US-A1- 2008 216 889
- US-A1- 2010 129 573
- US-A1- 2010 202 835

## Description

### Technical Field

This disclosure generally relates to films capable of use in a flexible photovoltaic solar module, rolls of films capable of use in a flexible photovoltaic solar module, processes of making the films and rolls of films, and to flexible photovoltaic solar modules including such films.

### Background

Emerging solar technologies such as organic photovoltaic devices (OPVs) and thin film solar cells like Copper Indium Gallium di-Selenide (CIGS) require protection from water vapor and need to be durable (e.g., to ultra-violet (UV) light) in outdoor environments. Typically, glass has been used as an encapsulating material for such solar devices because glass is a very good barrier to water vapor, is optically transparent, and is stable to UV light. However, glass is heavy, brittle, difficult to make flexible, and difficult to handle. There has been interest in developing transparent flexible encapsulating materials to replace glass that will not share the drawbacks of glass but have glass-like barrier properties and UV stability, and a number of flexible barrier films have been developed that approach the barrier properties of glass.

WO 2009/086095 A2 discloses an encapsulating film system comprising a flexible barrier film, an adhesive on at least a portion of the flexible barrier film, and a desiccant on at least a portion of the flexible barrier film or the adhesive.

### Summary

Because solar devices are used outdoors, they are exposed to the elements, including wind, water, and sunlight. Water penetration into solar panels has been a long-standing problem. Solar panels may also be deleteriously affected by wind and sunlight.

Many flexible barrier films are multilayer film laminates. Any multilayer film laminate has the potential for delamination, especially at the edges. Reducing delamination at the edges may improve overall barrier film performance. One way to reduce barrier film delamination is to introduce a protective layer around the perimeter of the barrier film such that the barrier layers and barrier film substrate are insulated from the environment.

The inventors of the present disclosure recognized that it may be desirable to provide barrier film edge protection in a continuous roll format. One reason for this is that roll-to-roll processing can reduce the cost of solar module manufacturing. Consequently, the inventors of the present disclosure discovered a novel process that provides the means to combine discontinuous barrier film sheets with edge protective layers and a weatherable top sheet in a roll-to-roll format. The inventors of the present disclosure also discovered novel films and rolls of films including discontinuous barrier film sheets, edge protective layer(s), and a weatherable top sheet in a roll format.

A method of forming a continuous multilayer film and a continuous multilayer film as defined by the independent claims are provided. The dependent claims define embodiments.

In some embodiments, a method of forming a continuous multilayer film, comprises: providing discrete segments of multilayer barrier film, wherein adjacent discrete segments of multilayer barrier film
are separated by a gap; and placing a protective layer adjacent to two adjacent discrete segments of multilayer barrier film such that at least a portion of the protective layer spans the gap to form a continuous film capable of use as a barrier film.

In some embodiments, a film includes a continuous multilayer film, comprising:
a weatherable sheet; segments of a multilayer barrier film; and a protective layer overlapping at least a portion of at least two adjacent segments of the multilayer barrier film; wherein the continuous multilayer film is capable of use as a barrier film in an electronic device.

In some embodiments, a roll of film includes any of the films described herein.

In some embodiments, a photovoltaic cell includes any of the films described herein.

In some embodiments, the protective layer is opaque. In some embodiments, the protective layer includes a protective sheet and an adhesive and is adjacent to the discrete segments of the multilayer barrier film. In some embodiments, the method further comprises placing a weatherable sheet adjacent to the multilayer barrier film. In some embodiments, the film further includes a weatherable sheet. In some embodiments, the weatherable sheet includes a fluoropolymer. In some embodiments, the fluoropolymer comprises at least one of an ethylene tetrafluoro-ethylene copolymer, a tetrafluoroethylene-hexafluoropropylene copolymer, a tetrafluoroethylene-hexafluoropropylene-vinylidene fluoride copolymer, or a polyvinylidene fluoride. In some embodiments, the method further comprises placing a pressure sensitive adhesive on the multilayer barrier film. In some embodiments, the film further includes a pressure sensitive adhesive on the multilayer barrier film. In some embodiments, the pressure sensitive adhesive includes at least one of an acrylate, a silicone, a polyisobutylene, and a urea. In some embodiments, the pressure sensitive adhesive comprises at least one of a UV stabilizer, a hindered amine light stabilizer, an antioxidant, and a thermal stabilizer. In some embodiments, each discrete segment of multilayer barrier film has a first side edge and a second side edge, and the method further comprises placing a protective layer adjacent to at least one of the first and second side edges of the discrete segments of multilayer barrier film to form a continuously edge protected barrier film wherein all edges of the discrete segments of multilayer barrier film are insulated from the environment. In some embodiments, the multilayer barrier film has a first major surface and a second major surface and the protective layer is adjacent to the first major surface, and the method further comprises placing a substrate adjacent to the second major surface of the multilayer barrier film. In some embodiments, the substrate comprises at least one of polyethylene terephthalate, polyethylene naphthalate, polyetheretherketone, polyaryletherketone, polyacrylate, polyetherimide, polyarylsulfone, polyethersulfone, polyamideimide, or polyimide. In some embodiments, the multilayer barrier film has a first major surface and a second major surface and the protective layer is adjacent to the first major surface, and the method further comprises placing an electronic device adjacent to the second major surface of the multilayer barrier film. In some embodiments, the method further comprises affixing the barrier film and electronic device construction adjacent to a roof. In some embodiments, the multilayer barrier film includes a polymer layer and an inorganic barrier layer. In some embodiments, the inorganic barrier layer is an oxide layer. In some embodiments, the multilayer barrier film includes at least two oxide layers. In some embodiments, the multilayer barrier film includes at least two polymers layers. In some embodiments, the protective layer is at least one of an ink layer, a metal foil layer, and an inorganic barrier layer. In some embodiments, the method further comprises forming a roll of the continuous multilayer film. In some embodiments, the roll includes a plurality of discrete sheets of barrier film. In some embodiments, the protective layer includes multiple segments each of which has a first terminal edge and a second terminal edge, and the method further comprises placing a segment of protective layer adjacent to two adjacent discrete segments of multilayer barrier film such that the first and second terminal edges of the segment of protective layer span the gap to form a continuous film capable of use as a barrier film.

The present disclosure allows for the combination of any of the disclosed elements or processes.

### Brief Description of the Drawings

The disclosure may be more completely understood in consideration of the following detailed description of various embodiments of the disclosure in connection with the accompanying drawings, in which:
Fig. 1 is schematic view of one exemplary process according to the present disclosure.
Fig. 2 is a schematic perspective view of an article made according to the process of Fig. 1.
Fig. 3 is a cross-sectional schematic drawing of an article in accordance with the teachings herein.
Fig. 4 is a schematic perspective view of an alternative article in accordance with the teachings herein.
Fig. 5 is a cross-sectional schematic drawing of an alternative article in accordance with the teachings herein.

### Detailed Description

Edge delamination is a concern for multilayer articles. Edge delamination can cause separation of the layers. Delamination can be controlled by the assessment, control, and modification of three inputs. The first input is the exposure to light at the interface(s) between the layers of the multilayer barrier film, including visible light and, in some embodiments, UV light. Water exposure is the second input. The third input is stress on the interface. Minimization and control of these three inputs reduces spontaneous delamination, defined herein as a peel of less than 20 grams/inch as measured according to ASTM D3330 -"Standard Test Method of Peel Adhesion of Pressure-Sensitive Tape."

The development of methods to prevent separation/delamination of the flexible barrier films in, for example, a photovoltaic device are especially valuable to the photovoltaic industry. The longer the photovoltaic module outputs power, the more valuable the photovoltaic module. In some embodiments, the present disclosure is directed to increasing photovoltaic module lifetime, without interfering with barrier properties of a flexible barrier film.

Where used, one exemplary currently used process for applying edge protection to barrier films is as follows. A barrier film is coated with an adhesive (*e.g*., pressure sensitive adhesive) to which a topsheet is applied. The resulting structure is cut into pieces having a desired size. Edge protection is then applied in a desired pattern. This process is time-consuming and required numerous steps. The inventors of the present disclosure recognized that significant manufacturing advantage could be achieved by making a roll-to-roll barrier film including edge protection. By eliminating many of the manufacturing steps, the manufacturing cost of the barrier film can be reduced, and as such, the manufacturing cost of the entire photovoltaic module including the barrier film can be reduced. By decreasing the cost of the entire solar module, generation of solar energy is less expensive and may be more widely adopted as an energy source, leading to an increase in adoption of green energy globally.

Some embodiments of the present disclosure relate to a method of producing a film and/or a roll of film. Some embodiments of the present disclosure relate to a method of producing a continuous, edge-protected barrier film and/or a roll of film.

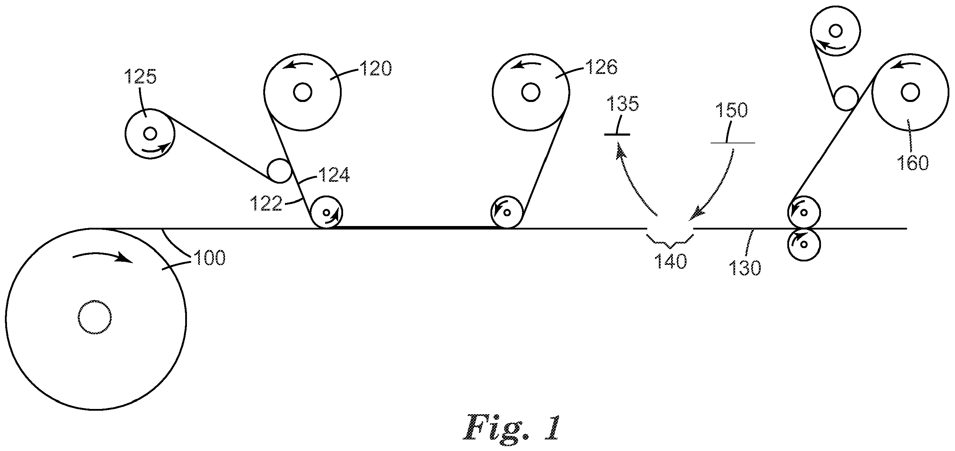

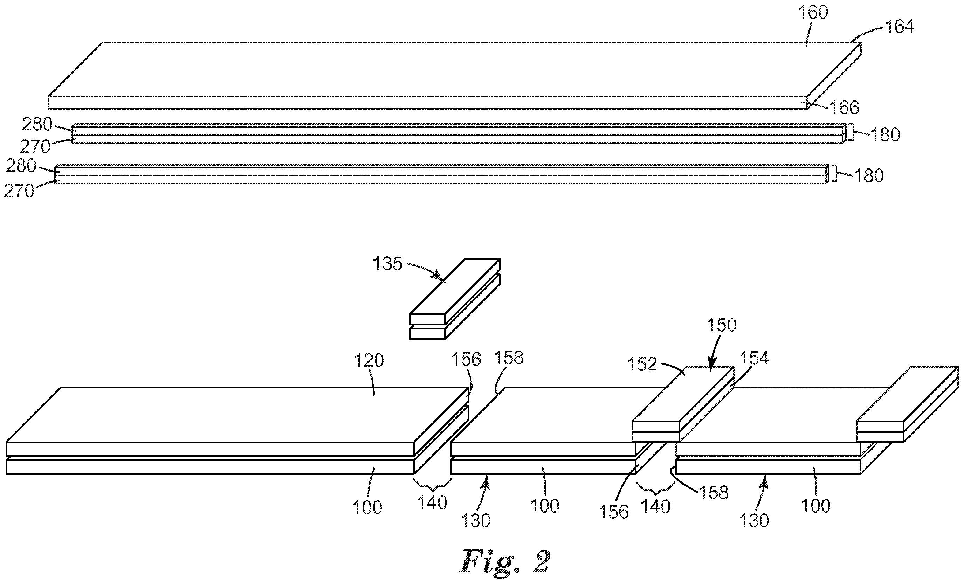

Fig. 1 illustrates one exemplary method according to the present disclosure, and Fig. 2 schematically illustrates the physical multilayer film construction made using the method shown in Fig. 1. As shown in Fig. 1, a barrier film 100 enters the manufacturing line. An adhesive 120 (shown as a pressure sensitive adhesive in Fig. 1) having a first liner on a first major surface 122 and a second liner on a second major surface 124 has its first liner removed in step 125 and is placed onto and/or laminated onto barrier film 100 with first major surface 122 adjacent to barrier film 100. The second liner of adhesive 120 is removed in step 126 to expose the second major surface 124 of adhesive 120.

Next, the barrier film/adhesive construction is cut in the crossweb direction into discrete segments 130 and a portion of the barrier film/adhesive construction is removed (removed portion 135) to form a gap 140 between adjacent discrete segments 130 of the multilayer barrier film 100 / adhesive 120 construction. In some embodiments, the gap is between about 3 mm and about 2 feet (600 mm). In some embodiments, the gap is between about 15 mm and about 200 mm. In some embodiments, the gap is approximately 50 mm.

Next, the removed portion 135 of the barrier film/adhesive construction is replaced with protective layer material 150 in the downweb direction, thereby reforming a continuous film. As shown in Fig. 1, this can be done as follows. A segment of a protective layer material 150 is placed on each of two adjacent discrete segments 130 of barrier film 100 / adhesive 120 construction such that the segment of protective layer material 150 spans gap 140 and touches or overlaps each of the two adjacent discrete segments 130 of barrier film 100 / adhesive 120 construction. In some embodiments, the protective layer 150 has a first terminal edge 152 and a second terminal edge 154 and the edges (152 and 154) touch and/or overlap the terminal edges 156 and 158 of each of the two adjacent discrete segments 130 of barrier film 100 / adhesive 120 construction.

In some embodiments (including, for example, that shown in Figs. 1 and 2), a single protective layer segment 150 overlaps each of the two adjacent discrete segments 130 of barrier film 100 / adhesive 120 construction. By overlapping with the discrete segments of barrier film 100 / adhesive 120 construction, protective layer segments 150 form a continuous sheet of material that can be rolled to form a roll of continuous material. Protective layer segments 150 also provide edge protection to the terminal edges 156 and 158 of discrete segments 130 of barrier film 100 / adhesive 120 construction.

In some embodiments where protective layer 150 overlaps barrier film 100 / adhesive 120 construction, the overlap can be of between about 1 mm and about 50 mm on each discrete segment 130 of barrier film 100 / adhesive 120 construction. In some embodiments, the overlap is between about 5 mm and about 20 mm on each discrete segment 130 of barrier film 100 / adhesive 120 construction. In some embodiments, the overlap is about 10 mm on each discrete segment 130 of barrier film 100 / adhesive 120 construction.

In some embodiments, protective layer 150 is a continuous layer that completely overlaps at least portions of barrier film 100 / adhesive 120 construction. In such embodiments, protective layer 150 may be transparent.

The last step shown in Fig. 1 is placing and/or laminating a continuous weatherable sheet 160 (whose liner has been removed, if present) on top of the barrier film 100 / adhesive 120 / protective layer 150 construction formed as described above. A continuous sheet of material including discrete segments of barrier material 100 whose adjacent edges are protected by a protective layer 150 and whose top surface (and in some embodiments, side edges) is protected by weatherable sheet 160 comes off the manufacturing line and can be rolled into a roll that can be sold. Thermal lamination may also be employed in bonding protective layer segment 150 shown in Fig 2.

In the specific embodiment shown in Fig. 1 (and Fig. 2), weatherable sheet 160 has been pretreated to include edge protecting material 180 along its downweb sides 164 and 166. Additional methods of attachment can be used, including, for example, bonding via thermal lamination.

In addition to the manufacturing advantages described above, this process and the resulting materials have the additional advantage of having the discrete segments of barrier material cut to the desired size for their intended end use, further reducing manufacturing steps and cost.

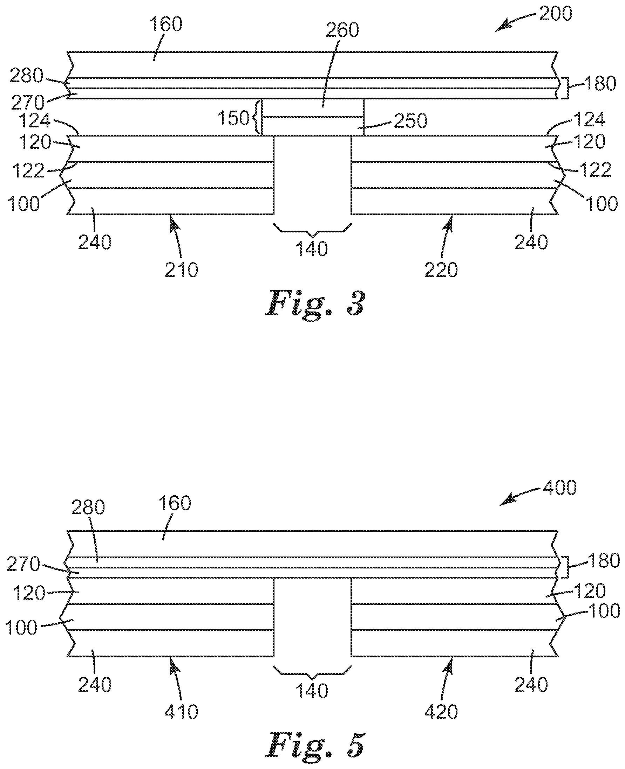

Some embodiments of the present disclosure relate to continuous multilayer films capable of use as a barrier film. Figs 2 and 3 shows one exemplary physical construction of a portion of the continuous made according to the methods described herein. Fig. 2 is a schematic, exploded perspective view that shows a portion of the continuous film barrier construction during processing. Fig. 3 is a cross-sectional view of a portion of the continuous film barrier construction.

The exemplary construction 200 shown in Fig. 3 includes two discrete segments 210 and 220. Each segment includes barrier film100, adhesive 120, and a substrate 240 (not shown in Fig. 2). On top of and overlapping segments 210 and 220 is a protective layer segment 150. Protective layer segment 150 is adjacent to second major surface 124 of adhesive layer 120. In the specific embodiment shown in Figs. 2 and 3, protective layer 150 includes a polymer layer 250 (*e.g.,* a black ETFE) and an adhesive layer 260 (*e.g.,* a pressure sensitive adhesive). On top of and overlapping protective layer segment 150 is a weatherable sheet 160. In the embodiment shown in Fig. 2 and 3, the downweb sides (164 & 166) of weatherable sheet 160 are adjacent to a protective layer material 180 (including a polymer layer 270 (*e.g.,* a black ETFE) and an adhesive layer 280 (*e.g.,* a pressure sensitive adhesive)) along the side edges of weatherable sheet 160.

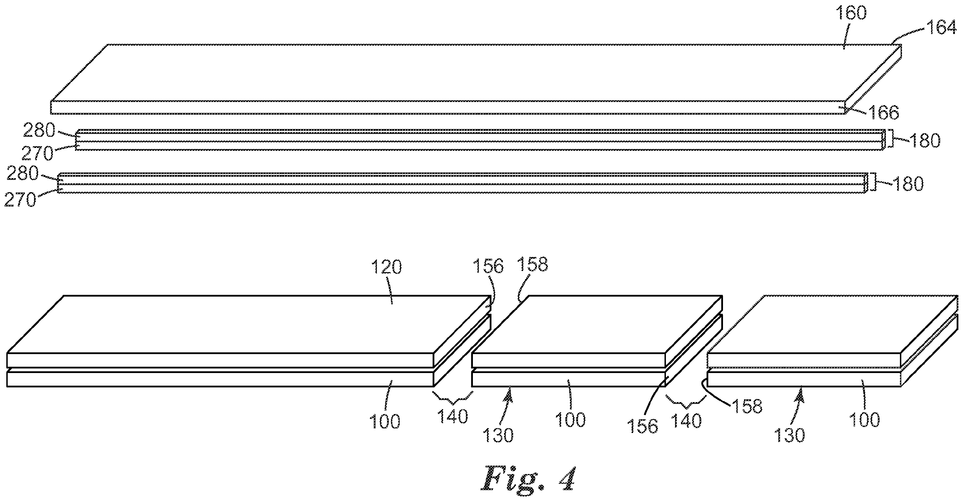

Fig. 4 and 5 show one exemplary alternative exemplary construction made in accordance with the method and teachings generally described herein. The assembly of Figs. 4 and 5 does not include protective layer segments between the terminal edges of adjacent discrete segments of barrier layer.

The individual layers of the continuous multilayer films described herein are discussed in greater detail below.

### Multilayer Barrier Film

As used herein, the term "barrier film" refers to films that provide a barrier to at least one of oxygen or water. Barrier films are typically selected such that they have oxygen and water transmission rates at a specified level as required by the specific application. In some embodiments, the barrier film has a water vapor transmission rate (WVTR) less than about 0.005 g/m²/day at 38° C and 100% relative humidity; in some embodiments, less than about 0.0005 g/m²/day at 38° C and 100% relative humidity; and in some embodiments, less than about 0.00005 g/m²/day at 38° C and 100% relative humidity. In some embodiments, the barrier film has a WVTR of less than about 0.05, 0.005, 0.0005, or 0.00005 g/m²/day at 50° C and 100% relative humidity or even less than about 0.005, 0.0005, 0.00005 g/m²/day at 85° C and 100% relative humidity. In some embodiments, the barrier film has an oxygen transmission rate of less than about 0.005 g/m²/day at 23° C and 90% relative humidity; in some embodiments, less than about 0.0005 g/m²/day at 23° C and 90% relative humidity; and in some embodiments, less than about 0.00005 g/m²/day at 23° C and 90% relative humidity.

Multilayer barrier films can be selected from a variety of constructions. Some exemplary useful multilayer barrier films include inorganic films prepared by atomic layer deposition, thermal evaporation, sputtering, and chemical vapor deposition. In some embodiments, the multilayer barrier films are flexible and/or transparent.

In some embodiments, the multilayer barrier film includes inorganic/organic multilayers. Flexible ultra-barrier films comprising inorganic/organic multilayers are described, for example, in U.S. Patent No. 7,018,713 (Padiyath et al.). Such flexible ultra-barrier films may have a first polymer layer disposed on polymeric film that may be overcoated with two or more inorganic barrier layers separated by additional second polymer layers. In some embodiments, the barrier film comprises one inorganic oxide interposed on a first polymer layer. Additional exemplary multilayer barrier films can also be found, for example, in U.S. Patent Nos. 4,696,719 (Bischoff), 4,722,515 (Ham), 4,842,893 (Yializis et al.), 4,954,371 (Yializis), 5,018,048 (Shaw et al.), 5,032,461(Shaw et al.), 5,097,800 (Shaw et al.), 5,125,138 (Shaw et al.), 5,440,446 (Shaw et al.), 5,547,908 (Furuzawa et al.), 6,045,864 (Lyons et al.), 6,231,939 (Shaw et al.) and 6,214,422 (Yializis); in published PCT Application No. WO 00/26973 (Delta V Technologies, Inc.); in D. G. Shaw and M. G. Langlois, "A New Vapor Deposition Process for Coating Paper and Polymer Webs", 6th International Vacuum Coating Conference (1992); in D. G. Shaw and M. G. Langlois, "A New High Speed Process for Vapor Depositing Acrylate Thin Films: An Update", Society of Vacuum Coaters 36th Annual Technical Conference Proceedings (1993); in D. G. Shaw and M. G. Langlois, "Use of Vapor Deposited Acrylate Coatings to Improve the Barrier Properties of Metallized Film", Society of Vacuum Coaters 37th Annual Technical Conference Proceedings (1994); in D. G. Shaw, M. Roehrig, M. G. Langlois and C. Sheehan, "Use of Evaporated Acrylate Coatings to Smooth the Surface of Polyester and Polypropylene Film Substrates", RadTech (1996); in J. Affinito, P. Martin, M. Gross, C. Coronado and E. Greenwell, "Vacuum deposited polymer/metal multilayer films for optical application", Thin Solid Films 270, 43 - 48 (1995); and in J.D. Affinito, M. E. Gross, C. A. Coronado, G. L. Graff, E. N. Greenwell and P. M. Martin, "Polymer-Oxide Transparent Barrier Layers." One exemplary commercially available barrier film is UBF 9L, which is commercially available from 3M Company.

In some embodiments, the multilayer barrier film is insulated from the environment. For the purpose of the present application, the barrier film is "insulated from the environment" when it has no interface with the air surrounding the assembly.

In embodiments including a substrate and where the barrier film and substrate are directly adjacent to one another, a major surface of the substrate can be treated to improve adhesion to the barrier film. Some exemplary surface treatments include electrical discharge in the presence of a suitable reactive or non-reactive atmosphere (*e.g*., plasma, glow discharge, corona discharge, dielectric barrier discharge or atmospheric pressure discharge); chemical pretreatment; or flame pretreatment. Some embodiments include a separate adhesion promotion layer may also be formed between the major surface of the substrate and the barrier film. The adhesion promotion layer can be, for example, a separate polymeric layer or a metal-containing layer such as a layer of metal, metal oxide, metal nitride, or metal oxynitride. In some embodiments, the adhesion promotion layer has a thickness of a few nanometers (nm) (*e.g.,* 1 or 2 nm) to about 50 nm or more. In some embodiments, one side (that is, one major surface) of the substrate can be treated to enhance adhesion to the barrier film, and the other side (that is, major surface) can be treated to enhance adhesion to a device to be covered or an encapsulant (*e.g.*, EVA or polyolefin) that covers such a device. Some useful substrates that are surface treated (*e.g.*, with solvent or other pretreatments) are commercially available, for example, from Du Pont Teijin. For some of these films, both sides are surface treated (*e.g.*, with the same or different pretreatments), and for others, only one side is surface treated.

In some embodiments, the multilayer barrier film is transmissive to visible and infrared light. The term "transmissive to visible and infrared light" as used herein means having an average transmission over the visible and infrared portion of the spectrum of at least about 75% measured along the normal axis. In some embodiments, the visible and infrared light-transmissive assembly has an average transmission over a range of 400 nm to 1400 nm of at least about 75% (in some embodiments at least about 80, 85, 90, 92, 95, 97, or 98%). Visible and infrared light-transmissive assemblies are those that do not interfere with absorption of visible and infrared light, for example, by photovoltaic cells. In some embodiments, the visible and infrared light-transmissive assembly has an average transmission over a range wavelengths of light that are useful to a photovoltaic cell of at least about 75% (in some embodiments at least about 80, 85, 90, 92, 95, 97, or 98%).

In some embodiments, the multilayer barrier film is flexible. The term "flexible" as used herein refers to being capable of being formed into a roll. In some embodiments, the term "flexible" refers to being capable of being bent around a roll core with a radius of curvature of up to 7.6 centimeters (cm) (3 inches). Some embodiments have a radius of curvature of up to 6.4 cm (2.5 inches), 5 cm (2 inches), 3.8 cm (1.5 inch), or 2.5 cm (1 inch). In some embodiments, the flexible assembly can be bent around a radius of curvature of at least 0.635 cm (1/4 inch), 1.3 cm (1/2 inch) or 1.9 cm (3/4 inch).

### Protective Layer

The protective layer can be any layer that blocks visible light (380 to 750 nm) from reaching the barrier film. In some embodiments, the protective layer is opaque. For the purpose of the present application, a layer is opaque if it causes a reduction in transmission of visible light (380 to 750 nm), specifically it reduces transmission between 380 and 450nm, thereby blocking it from reaching the barrier film. Generally, a layer is opaque if the addition of the layer creates a maximum of 20% transmission at any wavelength between 380 and 450 nm in the multilayer film. In some embodiments, the opaque layer creates a maximum transmission of 2% transmission at any wavelength between 380 and 450 nm. In specific embodiments, the opaque layer creates a maximum transmission of 0.2% transmission at any wavelength between 380 and 450 nm. Examples include an ink layer (*e.g*., ink from a permanent marker) and opaque tapes. One exemplary specific example is an opaque tape having a backing of a black ETFE (*e.g.,* ETFE (ethylene tetrafluoro ethylene) commercially available from Asahi Glass Ltd., Tokyo, Japan and laminated using a PSA such as 8172PCL, commercially available from 3M Company. In some embodiments, the backing may include a primer opposite the adhesive layer, such as 3M Tape Primer 94, commercially available from 3M Company. Where the opaque protective layer is an opaque tape, the tape may be in any orientation within the multilayer film. For example, the tape may be on the barrier film opposite the electronic device. The tape may also be on the weatherable sheet, either opposite the electronic device or on the same side as the electronic device. In such embodiments, where the tape is on the same side as the electronic device, the opaque tape can be covered by the weatherable sheet, offering an additional degree of protection for the opaque tape.

The protective layer can be any desired length and width. In some embodiments, the protective layer(s) may be placed in a perimeter of the assembly, or can form a frame around the surface of the assembly. Because of the stresses that are focused on the edge, delamination is generally more likely to start in or around the edges. Once delamination has begun, the "edge" may advance toward the opposite side of the multilayer article, eventually resulting in delamination of the entire interface between layers. Stopping the delamination at the edge will allow for the individual layers in a multilayer article to remain adhered.

In some embodiments, the light incident on the entire solar module is limited in at least a portion of the surface area, for example less than 5%, less than 1% or less than 0.5%. The light can be blocked continuously or in discontinuous pattern, *e.g*. dots, lines, symbols, letters, numbers, or graphics. It may also be beneficial to block light in a perimeter around the assembly, namely creating a frame of limited light transmission around the surface of the assembly.

In some embodiments, the protective layer is at least one of an ink layer, a metal foil layer, and a metal-free barrier layer, such as an inorganic barrier layer. Any metal foil layer can be used. In some embodiments, the metal foil is an aluminum foil. One commercially exemplary aluminum foil is sold by All Foils, Inc. Any inorganic layer can be used that will create a barrier to water without incurring the high cost of metal. Any ink layer can be used that will block light.

Figs. 2 and 3 illustrate some exemplary embodiments according to the present disclosure. In Figs. 2 and 3, the opaque protective layer completely surrounds the perimeter of each discrete segment of barrier layer.

### Weatherable Sheet

Some embodiments of the present disclosure include a weatherable sheet. The weatherable sheet can be monolayered or multilayered. In some embodiments, the weatherable sheet is flexible and/or transmissive to visible and infrared light and/or includes organic film-forming polymers. Some exemplary materials that can form weatherable sheets include polyesters, polycarbonates, polyethers, polyimides, polyolefins, fluoropolymers, and combinations thereof.

In embodiments wherein the electronic device is, for example, a solar device, it may be desirable for the weatherable sheet to be resistant to degradation by ultraviolet (UV) light. Photo-oxidative degradation caused by UV light (*e.g.*, light having a wavelength between about 280 and about 400 nm) may result in color change and deterioration of optical and mechanical properties of polymeric films. The weatherable sheets described herein can provide, for example, a durable, weatherable topcoat for a photovoltaic device. The substrates are generally abrasion and impact resistant and can prevent degradation of, for example, photovoltaic devices when they are exposed to outdoor elements.

A variety of stabilizers may be added to the weatherable sheet to improve its resistance to UV light. Examples of such stabilizers include at least one of ultraviolet absorbers (UVA) (*e.g.,* red shifted UV absorbers), hindered amine light stabilizers (HALS), and/or anti-oxidants. These additives are described in further detail below. In some embodiments, the phrase "resistant to degradation by ultraviolet light" means that the weatherable sheet includes at least one ultraviolet absorber or hindered amine light stabilizer. In some embodiments, the phrase "resistant to degradation by ultraviolet light" means that the weatherable sheet at least one of reflects or absorbs at least 50 percent of incident ultraviolet light over at least a 30 nanometer range in a wavelength range from at least 300 nanometers to 400 nanometers. In some embodiments, the weatherable sheet need not include UVA or HALS.

The UV resistance of the weatherable sheet can be evaluated, for example, using accelerated weathering studies. Accelerated weathering studies are generally performed on films using techniques similar to those described in ASTM G-155, "Standard practice for exposing non-metallic materials in accelerated test devices that use laboratory light sources". The noted ASTM technique is considered a sound predictor of outdoor durability, that is, ranking materials performance correctly. One mechanism for detecting the change in physical characteristics is the use of the weathering cycle described in ASTM G155 and a D65 light source operated in the reflected mode. Under the noted test, and when the UV protective layer is applied to the article, the article should withstand an exposure of at least 18,700 kJ/m² at 340 nm before the b* value obtained using the CIE L*a*b* space increases by 5 or less, 4 or less, 3 or less, or 2 or less before the onset of significant cracking, peeling, delamination or haze.

In some embodiments, the weatherable sheet disclosed herein comprises a fluoropolymer. Fluoropolymers typically are resistant to UV degradation even in the absence of stabilizers such as UVA, HALS, and anti-oxidants. Some exemplary fluoropolymers include ethylene-tetrafluoroethylene copolymers (ETFE), ethylene-chloro-trifluoroethylene copolymers (ECTFE), tetrafluoroethylene-hexafluoropropylene copolymers (FEP), tetrafluoroethylene-perfluorovinylether copolymers (PFA, MFA) tetrafluoroethylene-hexafluoropropylene-vinylidene fluoride copolymers (THV), polyvinylidene fluoride homo and copolymers (PVDF), blends thereof, and blends of these and other fluoropolymers. Fluoropolymers typically comprise homo or copolymers of TFE, CTFE, VDF, HFP, or other fully fluorinated, partially fluorinated or hydrogenated monomers such as vinyl ethers and alpa-olefins or other halogen containing monomers.

The CTE of fluoropolymer films is typically high relative to films made from hydrocarbon polymers. For example, the CTE of a fluoropolymer film may be at least 75, 80, 90, 100, 110, 120, or 130 ppm/K. For example, the CTE of ETFE may be in a range from 90 to 140 ppm/K.

In embodiments in which the substrate includes at least one fluoropolymer, the substrate and/or film can also include non-fluorinated materials. For example, a blend of polyvinylidene fluoride and polymethyl methacrylate can be used. Some exemplary flexible, visible, and infrared light-transmissive substrates include multilayer film substrates. Multilayer film substrates may have different fluoropolymers in different layers or may include at least one layer of fluoropolymer and at least one layer of a non-fluorinated polymer. Multilayer films can comprise a few layers *(e.g*., at least 2 or 3 layers) or can comprise at least 100 layers (*e.g*., in a range from 100 to 2000 total layers or more). The different polymers in the different multilayer film substrates can be selected, for example, to reflect a significant portion (*e.g*., at least 30, 40, or 50%) of UV light in a wavelength range from 300 to 400 nm as described, for example, in U.S. Patent No. 5,540,978 (Schrenk). Such blends and multilayer film substrates may be useful for providing UV resistant substrates that have lower CTEs than the fluoropolymers described above.

Useful weatherable sheets comprising a fluoropolymer can be commercially obtained, for example, from E.I. duPont De Nemours and Co., Wilmington, DE, under the trade designation "TEFZEL ETFE" and "TEDLAR", and films made from resins available from Dyneon LLC, Oakdale, MN, under the trade designations "DYNEON ETFE", "DYNEON THV", " DYNEON FEP", and " DYNEON PVDF", from St. Gobain Performance Plastics, Wayne, NJ, under the trade designation "NORTON ETFE", from Asahi Glass Ltd. under the trade designation "CYTOPS", and from Denka Kagaku Kogyo KK, Tokyo, Japan under the trade designation "DENKA DX FILM".

Some exemplary weatherable sheets not including fluoropolymers are reported to be resistant to degradation by UV light in the absence of UVA, HALS, and anti-oxidants. For example, certain resorcinol isophthalate/terephthalate copolyarylates, for example, those described in U. S. Patent Nos. 3,444, 129; 3,460,961; 3,492,261; and 3,503,779 are reported to be weatherable. Certain weatherable multilayer articles containing layers comprising structural units derived from a 1,3-dihydroxybenzene organodicarboxylate are reported in International Patent Application Publication No. WO 2000/061664, and certain polymers containing resorcinol arylate polyester chain members are reported in U. S. Patent No. 6,306,507. Block copolyester carbonates comprising structural units derived from at least one 1,3-dihydroxybenzene and at least one aromatic dicarboxylic acid formed into a layer and layered with another polymer comprising carbonate structural units are reported in US Patent Publication No. 2004/0253428. Weatherable sheets containing polycarbonate may have relatively high CTEs in comparison to polyesters, for example. The CTE of a weatherable sheet containing a polycarbonate may be, for example, about 70 ppm/K.

For any of the embodiments of the weatherable sheet described above, the major surface of the weatherable sheet (e*.g.*, fluoropolymer) can be treated to improve adhesion to a pressure sensitive adhesive. Useful surface treatments include electrical discharge in the presence of a suitable reactive or non-reactive atmosphere (*e.g*., plasma, glow discharge, corona discharge, dielectric barrier discharge or atmospheric pressure discharge); chemical pretreatment (*e.g.*, using alkali solution and/or liquid ammonia); flame pretreatment; or electron beam treatment. A separate adhesion promotion layer may also be formed between the major surface of the weatherable sheet and the PSA. In some embodiments, the weatherable sheet may be a fluoropolymer that has been coated with a PSA and subsequently irradiated with an electron beam to form a chemical bond between the substrate and the pressure sensitive adhesive; (*see, e.g.,* U. S. Patent No. 6,878,400 (Yamanaka et al.). Some useful weatherable sheets that are surface treated are commercially available, for example, from St. Gobain Performance Plastics under the trade designation "NORTON ETFE".

In some embodiments, the weatherable sheet has a thickness from about 0.01 mm to about 1 mm, in some embodiments, from about 0.05 mm to about 0.25 mm or from 0.05 mm to 0.15 mm.

### Adhesives

Known adhesives can be used. In some embodiments, a pressure sensitive adhesive ("PSA") is between the weatherable sheet and the barrier film. PSAs are well known to those of ordinary skill in the art to possess properties including the following: (1) aggressive and permanent tack, (2) adherence with no more than finger pressure, (3) sufficient ability to hold onto an adherend, and (4) sufficient cohesive strength to be cleanly removable from the adherend. Materials that have been found to function well as PSAs are polymers designed and formulated to exhibit the requisite viscoelastic properties resulting in a desired balance of tack, peel adhesion, and shear holding power. One exemplary commercially available adhesive is 8172PCL, sold by 3M Company.

One method useful for identifying pressure sensitive adhesives is the Dahlquist criterion. This criterion defines a pressure sensitive adhesive as an adhesive having a 1 second creep compliance of greater than 1 x 10⁻⁶ cm²/dyne as described in "Handbook of Pressure Sensitive Adhesive Technology", Donatas Satas (Ed.), 2nd Edition, p. 172, Van Nostrand Reinhold, New York, NY, 1989, incorporated herein by reference. Alternatively, since modulus is, to a first approximation, the inverse of creep compliance, pressure sensitive adhesives may be defined as adhesives having a storage modulus of less than about 1 x 10⁶ dynes/cm².

In some embodiments, the PSA does not flow and has sufficient barrier properties to provide slow or minimal infiltration of oxygen and moisture through the adhesive bond line. Also, in some embodiments, the PSA is generally transmissive to visible and infrared light such that it does not interfere with absorption of visible light, for example, by photovoltaic cells. The PSAs may have an average transmission over the visible portion of the spectrum of at least about 75% (in some embodiments at least about 80, 85, 90, 92, 95, 97, or 98%) measured along the normal axis. In some embodiments, the PSA has an average transmission over a range of 400 nm to 1400 nm of at least about 75% (in some embodiments at least about 80, 85, 90, 92, 95, 97, or 98%). Exemplary PSAs include acrylates, silicones, polyisobutylenes, ureas, and combinations thereof. Some useful commercially available PSAs include UV curable PSAs such as those available from Adhesive Research, Inc., Glen Rock, PA, under the trade designations "ARclear 90453" and "ARclear 90537" and acrylic optically clear PSAs available, for example, from 3M Company, St. Paul, MN, under the trade designations "OPTICALLY CLEAR LAMINATING ADHESIVE 8171", "OPTICALLY CLEAR LAMINATING ADHESIVE 8172CL", and "OPTICALLY CLEAR LAMINATING ADHESIVE 8172PCL".

In some embodiments, the PSA has a modulus (tensile modulus) up to 50,000 psi (3.4 x 10⁸ Pa). The tensile modulus can be measured, for example, by a tensile testing instrument such as a testing system available from Instron, Norwood, MA, under the trade designation "INSTRON 5900". In some embodiments, the tensile modulus of the PSA is up to 40,000, 30,000, 20,000, or 10,000 psi (2.8 x 10⁸ Pa, 2.1 x 10⁸ Pa, 1.4 x 10⁸ Pa, or 6.9 x 10⁸ Pa).

In some embodiments, the PSA is an acrylic or acrylate PSA. As used herein, the term "acrylic" or "acrylate" includes compounds having at least one of acrylic or methacrylic groups. Useful acrylic PSAs can be made, for example, by combining at least two different monomers (first and second monomers). Exemplary suitable first monomers include 2-methylbutyl acrylate, 2-ethylhexyl acrylate, isooctyl acrylate, lauryl acrylate, n-decyl acrylate, 4-methyl-2-pentyl acrylate, isoamyl acrylate, sec-butyl acrylate, and isononyl acrylate. Exemplary suitable second monomers include a (meth)acrylic acid (e.g., acrylic acid, methacrylic acid, itaconic acid, maleic acid, and fumaric acid), a (meth)acrylamide (e.g., acrylamide, methacrylamide, N-ethyl acrylamide, N-hydroxyethyl acrylamide, N-octyl acrylamide, N-t-butyl acrylamide, N,N-dimethyl acrylamide, N,N-diethyl acrylamide, and N-ethyl-N-dihydroxyethyl acrylamide), a (meth)acrylate (e.g., 2-hydroxyethyl acrylate or methacrylate, cyclohexyl acrylate, t-butyl acrylate, or isobornyl acrylate), N-vinyl pyrrolidone, N-vinyl caprolactam, an alpha-olefin, a vinyl ether, an allyl ether, a styrenic monomer, or a maleate.

Acrylic PSAs may also be made by including cross-linking agents in the formulation. Exemplary cross-linking agents include copolymerizable polyfunctional ethylenically unsaturated monomers (e.g., 1,6-hexanediol diacrylate, trimethylolpropane triacrylate, pentaerythritol tetraacrylate, and 1,2-ethylene glycol diacrylate); ethylenically unsaturated compounds which in the excited state are capable of abstracting hydrogen (e.g., acrylated benzophenones such as described in U.S. Pat. No. 4,737,559 (Kellen et al.), p-acryloxy-benzophenone, which is available from Sartomer Company, Exton, PA, monomers described in U.S. Pat. No. 5,073,611 (Rehmer et al.) including p-N-(methacryloyl-4-oxapentamethylene)-carbamoyloxybenzophenone, N-(benzoyl-p-phenylene)-N'-(methacryloxymethylene)-carbodiimide, and p-acryloxy-benzophenone); nonionic crosslinking agents which are essentially free of olefinic unsaturation and is capable of reacting with carboxylic acid groups, for example, in the second monomer described above (e.g., 1,4-bis(ethyleneiminocarbonylamino)benzene; 4,4-bis(ethyleneiminocarbonylamino)diphenylmethane; 1,8-bis(ethyleneiminocarbonylamino)octane; 1,4-tolylene diisocyanate; 1,6-hexamethylene diisocyanate, N,N'-bis-1,2-propyleneisophthalamide, diepoxides, dianhydrides, bis(amides), and bis(imides)); and nonionic crosslinking agents which are essentially free of olefinic unsaturation, are noncopolymerizable with the first and second monomers, and, in the excited state, are capable of abstracting hydrogen (e.g., 2,4-bis(trichloromethyl)-6-(4-methoxy)phenyl)-s-triazine; 2,4-bis(trichloromethyl)-6-(3,4-dimethoxy)phenyl)-s-triazine; 2,4-bis(trichloromethyl)-6-(3,4,5-trimethoxy)phenyl)-s-triazine; 2,4-bis(trichloromethyl)-6-(2,4-dimethoxy)phenyl)-s-triazine; 2,4-bis(trichloromethyl)-6-(3-methoxy)phenyl)-s-triazine as described in U.S. Pat. No. 4,330,590 (Vesley); 2,4-bis(trichloromethyl)-6-naphthenyl-s-triazine and 2,4-bis(trichloromethyl)-6-(4-methoxy)naphthenyl-s-triazine as described in U.S. Pat. No. 4,329,384 (Vesley)).

Typically, the first monomer is used in an amount of 80-100 parts by weight (pbw) based on a total weight of 100 parts of copolymer, and the second monomer is used in an amount of 0-20 pbw based on a total weight of 100 parts of copolymer. The crosslinking agent can be used in an amount of 0.005 to 2 weight percent based on the combined weight of the monomers, for example from about 0.01 to about 0.5 percent by weight or from about 0.05 to 0.15 percent by weight.

Acrylic or acrylate PSAs useful for practicing the present disclosure can be prepared, for example, by a solvent free, bulk, free-radical polymerization process (*e.g*., using heat, electron-beam radiation, or ultraviolet radiation). Such polymerizations are typically facilitated by a polymerization initiator (*e.g*., a photoinitiator or a thermal initiator). Exemplary photoinitiators include benzoin ethers such as benzoin methyl ether and benzoin isopropyl ether, substituted benzoin ethers such as anisoin methyl ether, substituted acetophenones such as 2,2-dimethoxy-2-phenylacetophenone, and substituted alpha-ketols such as 2-methyl-2-hydroxypropiophenone. Examples of commercially available photoinitiators include IRGACURE 651 and DAROCUR 1173, both available from Ciba-Geigy Corp., Hawthorne, NY, and LUCERIN TPO from BASF, Parsippany, NJ. Examples of suitable thermal initiators include, but are not limited to, peroxides such as dibenzoyl peroxide, dilauryl peroxide, methyl ethyl ketone peroxide, cumene hydroperoxide, dicyclohexyl peroxydicarbonate, as well as 2,2-azo-bis(isobutryonitrile), and t-butyl perbenzoate. Examples of commercially available thermal initiators include VAZO 64, available from ACROS Organics, Pittsburgh, PA, and LUCIDOL 70, available from Elf Atochem North America, Philadelphia, PA. The polymerization initiator is used in an amount effective to facilitate polymerization of the monomers (*e.g*., 0.1 part to about 5.0 parts or 0.2 part to about 1.0 part by weight, based on 100 parts of the total monomer content).

If a photocrosslinking agent is used, the coated adhesive can be exposed to ultraviolet radiation having a wavelength of about 250 nm to about 400 nm. The radiant energy in this range of wavelength required to crosslink the adhesive is about 100 millijoules/cm² to about 1,500 millijoules/cm², or more specifically, about 200 millijoules/cm² to about 800 millijoules/cm².

A useful solvent-free polymerization method is disclosed in U.S. Patent No. 4,379,201 (Heilmann et al.). Initially, a mixture of first and second monomers can be polymerized with a portion of a photoinitiator by exposing the mixture to UV radiation in an inert environment for a time sufficient to form a coatable base syrup, and subsequently adding a crosslinking agent and the remainder of the photoinitiator. This final syrup containing a crosslinking agent (*e.g*., which may have a Brookfield viscosity of about 100 centipoise to about 6000 centipoise at 23 C, as measured with a No. 4 LTV spindle, at 60 revolutions per minute) can then be coated onto the weatherable sheet. Once the syrup is coated onto the weatherable sheet, further polymerization and crosslinking can be carried out in an inert environment (*e.g*., nitrogen, carbon dioxide, helium, and argon, which exclude oxygen). A sufficiently inert atmosphere can be achieved by covering a layer of the photoactive syrup with a polymeric film, such as silicone-treated PET film, that is transparent to UV radiation or e-beam and irradiating through the film in air.

In some embodiments, PSAs useful for practicing the present disclosure comprise polyisobutylene. The polyisobutylene may have a polyisobutylene skeleton in the main or a side chain. Useful polyisobutylenes can be prepared, for example, by polymerizing isobutylene alone or in combination with n-butene, isoprene, or butadiene in the presence of a Lewis acid catalyst (for example, aluminum chloride or boron trifluoride).

Useful polyisobutylene materials are commercially available from several manufacturers. Homopolymers are commercially available, for example, under the trade designations "OPPANOL" and "GLISSOPAL" (e.g., OPPANOL B15, B30, B50, B100, B150, and B200 and GLISSOPAL 1000, 1300, and 2300) from BASF Corp. (Florham Park, NJ); "SDG", "JHY", and "EFROLEN" from United Chemical Products (UCP) of St. Petersburg, Russia. Polyisobutylene copolymers can be prepared by polymerizing isobutylene in the presence of a small amount (e.g., up to 30, 25, 20, 15, 10, or 5 weight percent) of another monomer such as, for example, styrene, isoprene, butene, or butadiene. Exemplary suitable isobutylene/isoprene copolymers are commercially available under the trade designations "EXXON BUTYL" (*e.g*., EXXON BUTYL 065, 068, and 268) from Exxon Mobil Corp., Irving, TX.; "BK-1675N" from UCP and "LANXESS" (e.g., LANXESS BUTYL 301, LANXESS BUTYL 101-3, and LANXESS BUTYL 402) from Sarnia, Ontario, Canada. Exemplary suitable isobutylene/styrene block copolymers are commercially available under the trade designation "SIBSTAR" from Kaneka (Osaka, Japan). Other exemplary suitable polyisobutylene resins are commercially available, for example, from Exxon Chemical Co. under the trade designation "VISTANEX", from Goodrich Corp., Charlotte, NC, under the trade designation "HYCAR", and from Japan Butyl Co., Ltd., Kanto, Japan, under the trade designation "JSR BUTYL".

A polyisobutylene useful for practicing the present disclosure may have a wide variety of molecular weights and a wide variety of viscosities. Polyisobutylenes of many different molecular weights and viscosities are commercially available.

In some embodiments of PSAs comprising polyisobutylene, the PSA further comprises a hydrogenated hydrocarbon tackifier (in some embodiments, a poly(cyclic olefin)). Some of these embodiments include about 5 to 90 percent by weight the hydrogenated hydrocarbon tackifier. In some embodiments, the poly(cyclic olefin)) is blended with about 10 to 95 percent by weight polyisobutylene, based on the total weight of the PSA composition. Useful polyisobutylene PSAs include adhesive compositions comprising a hydrogenated poly(cyclic olefin) and a polyisobutylene resin such as those disclosed in Int. Pat. App. Pub. No. WO 2007/087281 (Fujita et al.).

The "hydrogenated" hydrocarbon tackifier component may include a partially hydrogenated resin (*e.g.*, having any hydrogenation ratio), a completely hydrogenated resin, or a combination thereof. In some embodiments, the hydrogenated hydrocarbon tackifier is completely hydrogenated, which may lower the moisture permeability of the PSA and improve the compatibility with the polyisobutylene resin. The hydrogenated hydrocarbon tackifiers are often hydrogenated cycloaliphatic resins, hydrogenated aromatic resins, or combinations thereof. For example, some tackifying resins are hydrogenated C9-type petroleum resins obtained by copolymerizing a C9 fraction produced by thermal decomposition of petroleum naphtha, hydrogenated C5-type petroleum resins obtained by copolymerizing a C5 fraction produced by thermal decomposition of petroleum naphtha, or hydrogenated C5/C9-type petroleum resins obtained by polymerizing a combination of a C5 fraction and C9 fraction produced by thermal decomposition of petroleum naphtha. The C9 fraction can include, for example, indene, vinyl-toluene, alpha-methylstyrene, beta-methylstyrene, or a combination thereof. The C5 fraction can include, for example, pentane, isoprene, piperine, 1,3-pentadiene, or a combination thereof. In some embodiments, the hydrogenated hydrocarbon tackifier is a hydrogenated poly(cyclic olefin) polymer. In some embodiments, the hydrogenated poly(cyclic olefin) is a hydrogenated poly(dicyclopentadiene), which may provide advantages to the PSA *(e.g.,* low moisture permeability and transparency). The tackifying resins are typically amorphous and have a weight average molecular weight no greater than 5000 grams/mole.

Some suitable hydrogenated hydrocarbon tackifiers are commercially available under the trade designations "ARKON" (*e.g*., ARKON P or ARKON M) from Arakawa Chemical Industries Co., Ltd. (Osaka, Japan); "ESCOREZ" from Exxon Chemical.; "REGALREZ" (*e.g*., REGALREZ 1085, 1094, 1126, 1139, 3102, and 6108) from Eastman (Kingsport, TN); "WINGTACK" (*e.g*., WINGTACK 95 and RWT-7850) resins from Cray Valley (Exton, PA); "PICCOTAC" (*e.g.*, PICCOTAC 6095-E, 8090-E, 8095, 8595, 9095, and 9105) from Eastman; "CLEARON", in grades P, M and K, from Yasuhara Chemical, Hiroshima, Japan; "FORAL AX" and "FORAL 105" from Hercules Inc., Wilmington, DE; "PENCEL A", "ESTERGUM H", "SUPER ESTER A", and "PINECRYSTAL" from Arakawa Chemical Industries Co., Ltd., Osaka, Japan; from Arakawa Chemical Industries Co., Ltd.); "EASTOTAC H" from Eastman; and "IMARV" from Idemitsu Petrochemical Co., Tokyo, Japan.

Optionally, PSAs useful for practicing the present disclosure (including any of the embodiments of PSAs described above) comprise at least one of a UV absorber (UVA), a hindered amine light stabilizer, or an antioxidant. Examples of useful UVAs include those described above in conjunction with multilayer film substrates (*e.g*., those available from Ciba Specialty Chemicals Corporation under the trade designations "TINUVIN 328", "TINUVIN 326", "TINUVIN 783", "TINUVIN 770", "TINUVIN 479", "TINUVIN 928", and "TINUVIN 1577"). UVAs, when used, can be present in an amount from about 0.01 to 3 percent by weight based on the total weight of the pressure sensitive adhesive composition. Examples of useful antioxidants include hindered phenol-based compounds and phosphoric acid ester-based compounds and those described above in conjunction with multilayer film substrates (*e.g.*, those available from Ciba Specialty Chemicals Corporation under the trade designations "IRGANOX 1010", "IRGANOX 1076", and "IRGAFOS 126" and butylated hydroxytoluene (BHT)). Antioxidants, when used, can be present in an amount from about 0.01 to 2 percent by weight based on the total weight of the pressure sensitive adhesive composition. Examples of useful stabilizers include phenol-based stabilizers, hindered amine-based stabilizers (*e.g*., including those described above in conjunction with multilayer film substrates and those available from BASF under the trade designation "CHIMASSORB" such as "CHIMASSORB 2020"), imidazole-based stabilizers, dithiocarbamate-based stabilizers, phosphorus-based stabilizers, and sulfur ester-based stabilizers. Such compounds, when used, can be present in an amount from about 0.01 to 3 percent by weight based on the total weight of the pressure sensitive adhesive composition.

In some embodiments, the PSA layer disclosed herein is at least 0.005 mm (in some embodiments, at least 0.01, 0.02, 0.03, 0.04, or 0.05 mm) in thickness. In some embodiments, the PSA layer has a thickness up to about 0.2 mm (in some embodiments, up to 0.15, 0.1, or 0.075 mm) in thickness. For example, the thickness of the PSA layer may be in a range from 0.005 mm to 0.2 mm, 0.005 mm to 0.1 mm, or 0.01 to 0.1 mm.

Once the PSA layer has been applied to the weatherable sheet, the exposed major surface may be temporarily protected with a release liner before being applied to a barrier film disclosed herein. Examples of useful release liners include craft paper coated with, for example, silicones; polypropylene film; fluoropolymer film such as those available from E.I. du Pont de Nemours and Co. under the trade designation "TEFLON"; and polyester and other polymer films coated with, for example, silicones or fluorocarbons.

A variety of stabilizers may be added to the PSA layer to improve its resistance to UV light. Examples of such stabilizers include at least one of ultra violet absorbers (UVA) (*e.g*., red shifted UV absorbers), hindered amine light stabilizers (HALS), or anti-oxidants.

Without wanting to be bound by theory, it is believed that the PSA layer in the barrier assembly according to the present disclosure serves to protect the barrier assembly from thermal stresses that may be caused by a high CTE weatherable sheet (*e.g.,* a fluoropolymer). Furthermore, even in embodiments wherein the CTE mismatch between the first and weatherable sheets is relatively low (*e.g.,* less than 40 ppm/K) the PSA layer serves as a convenient means for attaching the weatherable sheet to the barrier film deposited on the first polymeric film substrate (*e.g*., having a CTE of up to 50 ppm/K). When the PSA layer contains at least one of UVA, HALS, or anti-oxidants, it can further provide protection to the barrier film from degradation by UV light.

### Substrates

Some embodiments of the present disclosure include a substrate (see, for example, Fig. 3). Generally, the substrate is a polymeric film. In the context of the present disclosure, the term "polymeric" will be understood to include organic homopolymers and copolymers, as well as polymers or copolymers that may be formed in a miscible blend, for example, by co-extrusion or by reaction, including transesterification. The terms "polymer" and "copolymer" include both random and block copolymers.

The substrate may be selected, for example, so that its CTE is about the same (*e.g*., within about 10 ppm/K) or lower than the CTE of the electronic device (*e.g*., flexible photovoltaic device). In other words, the substrate may be selected to minimize the CTE mismatch between the substrate and the electronic device. In some embodiments, the substrate has a CTE that is within 20, 15, 10, or 5 ppm/K of the device to be encapsulated. In some embodiments, it may be desirable to select the substrate that has a low CTE. For example, in some embodiments, the substrate has a CTE of up to 50 (in some embodiments, up to 45, 40, 35, or 30) ppm/K. In some embodiments, the CTE of the substrate is in a range from 0.1 to 50, 0.1 to 45, 0.1 to 40, 0.1 to 35, or 0.1 to 30 ppm/K. When the substrate is selected, the difference between the CTE of the substrate and the weatherable sheet (described below) may be, in some embodiments, at least 40, 50, 60, 70, 80, 90, 100, or 110 ppm/K. The difference between the CTE of the substrate and the weatherable sheet may be, in some embodiments, up to 150, 140, or 130 ppm/K. For example, the range of the CTE mismatch between the substrate and the weatherable sheet may be, for example, 40 to 150 ppm/K, 50 to 140 ppm/K, or 80 to 130 ppm/K. The CTE can be determined by thermal mechanical analysis. And the CTE of many substrates can be found in product data sheets or handbooks.

In some embodiments, the substrate has a modulus (tensile modulus) up to 5 x 10⁹ Pa. The tensile modulus can be measured, for example, by a tensile testing instrument such as a testing system available from Instron, Norwood, MA, under the trade designation "INSTRON 5900". In some embodiments, the tensile modulus of the substrate is up to 4.5 x 10⁹ Pa, 4 x 10⁹ Pa, 3.5 x 10⁹ Pa, or 3 x 10⁹ Pa.

In some embodiments, the substrate is heat-stabilized (*e.g*., using heat setting, annealing under tension, or other techniques) to minimize shrinkage up to at least the heat stabilization temperature when the support is not constrained. Exemplary suitable materials for the substrate include polyethylene terephthalate (PET), polyethylene naphthalate (PEN), polyetheretherketone (PEEK), polyaryletherketone (PAEK), polyarylate (PAR), polyetherimide (PEI), polyarylsulfone (PAS), polyethersulfone (PES), polyamideimide (PAI), and polyimide, any of which may optionally be heat-stabilized. These materials are reported to have CTEs of in a range from <1 to about 42 ppm/K. Exemplary substrates are commercially available from a variety of sources. Polyimides are available, for example, from E.I. Dupont de Nemours & Co., Wilmington, DE, under the trade designation "KAPTON" (*e.g*, "KAPTON E" or "KAPTON H"); from Kanegafugi Chemical Industry Company under the trade designation "APICAL AV"; from UBE Industries, Ltd., under the trade designation "UPILEX". Polyethersulfones are available, for example, from Sumitomo. Polyetherimides are available, for example, from General Electric Company, under the trade designation "ULTEM". Polyesters such as PET are available, for example, from DuPont Teijin Films, Hopewell, VA.

In some embodiments, the substrate has a thickness from about 0.01 mm to about 1 mm, in some embodiments, from about 0.1 mm to about 0.5 mm or from 0.1 mm to 0.25 mm. Thicknesses outside these ranges may also be useful, depending on the application. In some embodiments, the substrate has a thickness of at least 0.01, 0.05, 0.06, 0.07, 0.08, 0.09, 0.1, 0.11, 0.12, or 0.13 mm.

### Other Optional Components

Optionally, assemblies according to the present disclosure can contain desiccant. In some embodiments, assemblies according to the present disclosure are essentially free of desiccant. "Essentially free of desiccant" means that desiccant may be present but in an amount that is insufficient to effectively dry a photovoltaic module. Assemblies that are essentially free of desiccant include those in which no desiccant is incorporated into the assembly.

Various functional layers or coatings can optionally be added to the assemblies disclosed herein to alter or improve their physical or chemical properties. Exemplary useful layers or coatings include visible and infrared light-transmissive conductive layers or electrodes (e.g., of indium tin oxide); antistatic coatings or films; flame retardants; abrasion resistant or hardcoat materials; optical coatings; anti-fogging materials; anti-reflection coatings; anti-smudging coatings; polarizing coatings; anti-fouling materials; prismatic films; additional adhesives (e.g., pressure sensitive adhesives or hot melt adhesives); primers to promote adhesion to adjacent layers; additional UV protective layers; and low adhesion backsize materials for use when the barrier assembly is to be used in adhesive roll form. These components can be incorporated, for example, into the barrier film or can be applied to the surface of the polymeric film substrate.

Other optional features that can be incorporated into the assembly disclosed herein include graphics and spacer structures. For example, the assembly disclosed herein could be treated with inks or other printed indicia such as those used to display product identification, orientation or alignment information, advertising or brand information, decoration, or other information. The inks or printed indicia can be provided using techniques known in the art (e.g., screen printing, inkjet printing, thermal transfer printing, letterpress printing, offset printing, flexographic printing, stipple printing, and laser printing). Spacer structures could be included, for example, in the adhesive, to maintain specific bond line thickness.

Assemblies according to the present disclosure can conveniently be assembled using a variety of techniques. For example, the pressure sensitive adhesive layer may be a transfer PSA on a release liner or between two release liners. The transfer adhesive can be used to laminate the weatherable sheet to a barrier film deposited on a weatherable sheet after removal of the release liner(s). In another example, a PSA can be coated onto the weatherable sheet and/or onto the barrier film deposited on the first polymeric film substrate before laminating the first and weatherable sheets together. In a further example, a solvent-free adhesive formulation, for example, can be coated between the weatherable sheet and the barrier film deposited on the first polymeric film substrate. Subsequently, the formulation can be cured by heat or radiation as described above to provide an assembly according to the present disclosure.

Some embodiments of the present disclosure relate to a roll of the multilayer films described above.

The films and rolls of film of the present disclosure can be used in a flexible solar assembly as the barrier film. Such an assembly includes an electronic device adjacent to one embodiment of the barrier film 100 assemblies generally as described herein. Electronic devices that can be used in the assemblies according to the present disclosure include, for example, photovoltaic cells. Exemplary photovoltaic cells include those that have been developed with a variety of materials each having a unique absorption spectra that converts solar energy into electricity. Examples of materials used to make photovoltaic cells and their solar light absorption band-edge wavelengths include: crystalline silicon single junction (about 400 nm to about 1150 nm), amorphous silicon single junction (about 300 nm to about 720 nm), ribbon silicon (about 350 nm to about 1150 nm), CIS (Copper Indium Selenide) (about 400 nm to about 1300 nm), CIGS (Copper Indium Gallium di-Selenide) (about 350 nm to about 1100 nm), CdTe (about 400 nm to about 895 nm), GaAs multi-junction (about 350 nm to about 1750 nm). The shorter wavelength left absorption band edge of these semiconductor materials is typically between 300 nm and 400 nm. In specific embodiments, the electronic device is a CIGS cell. In some embodiments, the solar device (e.g., the photovoltaic cell) to which the assembly is applied comprises a flexible film substrate, resulting in a flexible photovoltaic device.

In some embodiments, the solar assembly includes an encapsulant. In some embodiments, an encapsulant can be applied over and around the photovoltaic cell and associated circuitry. Some exemplary encapsulants include ethylene vinyl acetate (EVA), polyvinyl butraldehyde (PVB), polyolefins, thermoplastic urethanes, clear polyvinylchloride, and ionomers. In some embodiments, the electronic device comprises an edge seal to seal it at the edges. For example, an edge seal material is applied over and around the sides of the photovoltaic cell and associated circuitry. In some examples,

In some embodiments, the solar assembly includes a backsheet. Exemplary backsheets are polymeric films, and in many embodiments are multilayer polymer films. One commercially available example of a backsheet films is the 3M™ Scotchshield™ film commercially available from 3M Company, Saint Paul, Minnesota. The backsheet may be connected to a building material, such as a roofing membrane (for example, in building integrated photovoltaics (BIPV)).

Embodiments and advantages of this disclosure are further illustrated by the following nonlimiting examples, but the particular materials and amounts thereof recited in these examples, as well as other conditions and details, should not be construed to unduly limit this disclosure.

### EXAMPLES

### Materials

UBF 9L: "3M™ Ultra Barrier Solar Film 9L" commercially available from 3M Company
UBF 5S: "3M™ Ultra Barrier Solar Film 5S" available from 3M Company
8172PCL: "3M OPTICALLY CLEAR ADHESIVE 8172PCL" commercially available from 3M Company, St. Paul, MN.
ETFE: ethylene-tetrafluoroethylene film with surface treatment (C-treated) available from St. Gobain Performance Plastics, Wayne, NJ under the trade name "NORTON® ETFE".
Opaque ETFE: black ethylene-tetrafluoroethylene film with surface treatment (DCS) "Film 25GB 1150DCS 2010" commercially available from Asahi Glass., LTD. Tokoyo, Japan under the trade name "FLUON® ETFE".
Primer 94: "3M™ Tape Primer 94" commercially available from 3M Company, St. Paul, MN.

### Comparative Example 1

A sample of "UBF 9L" barrier film laminate, commercially available from 3M Company, St.Paul, MN, was cut into 1.3 cm (0.5 in) x 13 cm (5 in) strips. Approximately 1.3 cm (0.5 in.) of the weatherable topsheet was removed from the "UBF 9L" creating a tab for peel testing. A 180 degree peel test was run using an "IMASS SLIP PEELSP-2000" tester commercially available from IMASS, Inc., Accord, MA. ASTM D3330 Method A was followed with the following modifications. The 1.3 cm (0.5 in) x 13 cm (5 in) strip was adhered to the IMASS testing platform using hand pressure via 38 mm (1.5 in) wide "3M Removable Repositionable Tape 655 Clear" double stick tape, available from 3M Company St. Paul, MN, with the weatherable sheet tabbed side facing up. The 1.3 cm (0.5 in) weatherable sheet tab was placed in the peel tester such that the peel angle was 180 degrees. The peel adhesion was measured at an angle of 180 degrees, a rate of 31 cm (12 in)/min and the adhesion values were collected over a 20 sec average using a .1 sec delay. The 20 sec peel average is reported in lbs./in. A total of 4 samples were averaged and are reported in Table 1.

Another sample of "UBF 9L" barrier film laminate was cut into a 7.6 cm (3 in) x 13 cm (5 in) piece.

### Peel Adhesion Test of Comparative Example 1

Comparative Sample 1 was placed into a xenon arc light weathering apparatus with daylight filters operated according to ASTM G155. The specimens were exposed to a total radiant dosage over the range of 290 nm - 800 nm of nominally 1187 MJ/m². After light exposure, samples were then cut into four 1.3 cm (½ in) x 13 cm (5 in) strips and measured for peel adhesion in the same manner as before the light exposure. Care was taken to ensure that the samples tested for peel adhesion were not shielded from the weathering apparatus light via the sample holders. A total of 4 samples were averaged and are reported in Table 1.

### Example 1

A sample of "UBF 9L" barrier film laminate was cut into a 7.6 cm (3 in) x 13 cm (5 in) piece. A piece of "3M PAINT REPLACEMENT TAPE (APPLIQUE) 5004", commercially available from 3M Company, St.Paul, MN was adhered to the weatherable topsheet of the "UBF 9L" laminate. The protective liner on the applique film was removed thereby exposing the pressure sensitive adhesive and adhered to the "UBF 9L" via hand pressure. This article is meant to simulate a light blocked edge of "UBF 9L". This sample was then cut into 1.3 cm (0.5 in) x 13 cm (5 in) strips and measured for peel adhesion in the same manner as Comparative Example 1. A total of 4 samples were measured and the average of the 4 samples combined is reported in Table 1.

### Light Exposure and Peel Test Results

A sample of the Example 1 assembly was placed into a xenon arc light weathering apparatus with daylight filters operated according to ASTM G155. The specimen was exposed to a total radiant dosage over the range of 290 nm - 800 nm of nominally 1187 MJ/m². After light exposure, the sample was cut into 1.3 cm (0.5 in) x 13 cm (5 in) strips and measured for peel adhesion in the same manner as before the light exposure. A total of 4 samples were measured and the average of the 4 samples is reported in Table 1.

**Table 1. Peel Strength Before and After Light Exposure**

| Example | Peel strength N/mm (lbs/in) before light exposure | Peel strength N/mm (lbs/in) after light exposure |
|---|---|---|
| Comparative Example 1 | 0.35 (2.0) | 0.008 (0.044) |
| Example 1 | 0.55 (3.1) | 1.4 (7.8) |

### Example 2

A sheet of "UBF 5S" barrier film, available from 3M Company, St. Paul, MN (3 inches x 5 inches) comprising a PET substrate and a barrier stack, the barrier stack comprising an acrylic polymer layer and an oxide layer was used to prepare a multi-layer film laminate comprising an opaque protective layer and a weatherable topsheet. The barrier coated side of the "UBF 5S" barrier film laminate was colored with a black "SHARPIE" brand permanent marker (commercially available from Sanford Corp., Oakbrook, IL.) such that the entire UBF 5S" barrier film laminate was essentially opaque (as defined herein). A piece of acrylic pressure sensitive adhesive (commercially available from 3M Company, St.Paul, MN under the trade designation "Optically Clear Adhesive 8172PCL"), with one liner removed was hand laminated to the "SHARPIE" brand ink layer. The adhesive release liner was subsequently removed and laminated to the C-treat side of a 34 cm (13.5 in) slit roll of 50 micron (2 mil) ethylenetetrafluoroethylene (ETFE) film commercially available from St. Gobain, Courbevoie, France. The resulting multi-layer film laminate comprised an essentially opaque ink layer and was made such that peel adhesion samples could be cut and peeled. The resulting assembly was meant to mimic the edge of a barrier assembly.

### Comparative Example 2

Example 2 was repeated identically except that no "SHARPIE" brand ink was applied.

### Light Exposure and Peel Test Results

The final multilayer assemblies of Example 2 and Comparative Example 2 were exposed in a xenon arc light weathering apparatus with daylight filters operated according to ASTM G155. The specimens were exposed to a total radiant dosage over the range of 290nm - 800nm of nominally 1187 MJ/m². After light exposure, the assemblies were cut into 1.3 cm (0.5 in) x 13 cm (5 in) strips. Approx. 1.3 cm (0.5 in) of the ETFE was removed from the "UBF 5S" barrier film laminate creating a tab for peel testing. A 180 degree peel test was run using an "IMASS SLIP PEELSP-2000" tester commercially available from IMASS, Inc., Accord, MA. ASTM D3330 Method A was followed with the following modifications. The 1.3 cm (0.5 in) x 13 cm (5 in) strip was adhered to the IMASS testing platform via (38.1 mm (1.5 in) wide "3M Removable Repositionable Tape 655 Clear", available from 3M Company St. Paul, MN) double stick tape using hand pressure with the ETFE tabbed side facing up. The 1.3 cm (0.5 in) ETFE tab was placed in the peel tester such that the peel angle was 180 degrees. The peel adhesion was measured at an angle of 180 degrees, a rate of 31 cm (12 in)/min and the adhesion values were collected over a 20 sec average using a .1 sec delay. A total of 4 samples were measured and the average of the 4 samples is reported.

**Table 2. Peel Strength Before and After Light Exposure**

| Example | Peel strength N/mm (lbs/in) before light exposure | Peel strength N/mm (lbs/in) after light exposure |
|---|---|---|
| Comparative Example 2 | 0.41 (1.8) | 0.0016 (0.0071) |
| Example 2 | 0.14 (0.62) | 0.18 (0.80) |

The above examples demonstrate the benefit of a light blocking layer. The following Example 3 describes one exemplary method to incorporate a light blocking layer in a continuous fashion such that the final assembly includes an opaque protective layer adjacent the barrier stack opposite the electronic device, a weatherable sheet adjacent the barrier stack opposite the substrate, wherein the multilayer film is transparent and flexible and the barrier stack and the substrate are insulated from the environment.

### Example 3 (Continuous Edge Protected Barrier Assembly)

A previously slit roll of black ETFE (25 um thick by 330 mm wide by approximately 100 m long) DCS primed film, commercially available from Asahi Glass, LTD. Tokoyo, Japan was laminated to a roll of 3M OPTICALLY CLEAR ADHESIVE 8172PCL pressure sensitive adhesive (310mm wide by approximately 100m long), commercially available from 3M Company, St. Paul, MN. This roll was than coated with 3M™ Tape Primer 94 commercially available from 3M Company, St. Paul, MN on the opposite side of the black ETFE at the 3M recommended coat weight. The resulting roll of tape was than slit to the appropriate widths such as 20mm and 70mm.

A roll of 3M™ Ultra Barrier Solar Film 5S (325mm wide by approximately 100m long), available from 3M was laminated (barrier side facing) to a roll of 3M OPTICALLY CLEAR ADHESIVE 8172PCL pressure sensitive adhesive (310mm wide by approximately 100m long), commercially available from 3M Company, St. Paul, MN. The resulting laminate was slit to a final slit width of 305mm. Second, the protective liner was removed from the 8172PCL adhesive followed by removal of a section of 8172PCL and UBF 5S (305mm wide by 50 mm long). Third, the removed section of 8172PCL and UBF 5S was replaced with an opaque protective tape section (305 mm wide by 70mm long) as described above. This step was repeated every 3 meters. Fourth, two rolls of opaque protective tape (20mm wide by approximately 100m long) described in above were laminated to a 305mm wide by approximately 100m long) roll of 2 mil C-treated clear ETFE commercially available St. Gobain Performance Plastics, Wayne, NJ under the trade name "NORTON® ETFE". The opaque protective tape was laminated to the C-Treated side of the ETFE such that each end was covered by the opaque protective tape for the entire length of the ETFE roll. Fifth, the C-treated side of the clear ETFE was than laminated to the 8712p exposed surface of the laminated formed in step 3. The result is continuous final assembly that includes an opaque protective layer surrounding a predefined barrier film of specific width and length dimensions and a weatherable sheet adjacent the barrier stack opposite the substrate.

## Claims

1. A method of forming a continuous multilayer film, comprising:
providing discrete segments (130; 210, 220) of multilayer barrier film (100), wherein adjacent discrete segments (130; 210, 220) of multilayer barrier film are separated by a gap (140);
placing a protective layer (150; 180) adjacent to two adjacent discrete segments (130; 210, 220) of multilayer barrier film (100) such that at least a portion of the protective layer (150; 180) spans the gap (140) to form a continuous film capable of use as a barrier film (100); and
placing a weatherable sheet (160) adjacent to the multilayer barrier film (100),
wherein the multilayer barrier film (100) has a water vapor transmission rate of less than about 0.05 g/m²/day at 38° C and 100% relative humidity,
wherein the multilayer barrier film (100) is transmissive to visible and infrared light, and
wherein the protective layer (150) is opaque.

2. The method of claim 1, wherein the protective layer (150; 180) includes a protective sheet (250; 270) and an adhesive (260; 280); and wherein the protective sheet (250; 270) is adjacent to the discrete segments (130; 210, 220) of the multilayer barrier film (100).

3. The method of any of the previous claims, further comprising:
placing a pressure sensitive adhesive (120) on the multilayer barrier film (100).

4. The method of claim 3, wherein the pressure sensitive adhesive (120) comprises at least one of a UV stabilizer, a hindered amine light stabilizer, an antioxidant, and a thermal stabilizer.

5. The method of any of the previous claims, wherein each discrete segment (130; 210, 220) of multilayer barrier film (100) has a first side edge (156) and a second side edge (158), and wherein the method further comprises:
placing a protective layer (150; 180) adjacent to at least one of the first and second side edges of the discrete segments (130; 210, 220) of multilayer barrier film (100) to form a continuously edge protected barrier film wherein all edges (156, 158) of the discrete segments (130; 210, 220) of multilayer barrier film (100) are insulated from the environment.

6. The method of any of the previous claims, wherein the multilayer barrier film (100) has a first major surface and a second major surface and the protective layer (150) is adjacent to the first major surface, further comprising:
placing a substrate (240) adjacent to the second major surface of the multilayer barrier film (100).

7. The method of claim 6, wherein the substrate (240) comprises at least one of polyethylene terephthalate, polyethylene naphthalate, polyetheretherketone, polyaryletherketone, polyacrylate, polyetherimide, polyarylsulfone, polyethersulfone, polyamideimide, or polyimide.

8. The method of any of the previous claims, wherein the multilayer barrier film (100) has a first major surface and a second major surface and the protective layer (150) is adjacent to the first major surface, further comprising:
placing an electronic device adjacent to the second major surface of the multilayer barrier film (100).

9. A continuous multilayer film, comprising:
a weatherable sheet (160);
segments (130; 210, 220) of a multilayer barrier film (100); and
a protective layer (150; 180) overlapping at least a portion of at least two adjacent segments (130; 210, 220) of the multilayer barrier film (100);
wherein the continuous multilayer film is capable of use as a barrier film (100) in an electronic device,
wherein the multilayer barrier film (100) has a water vapor transmission rate of less than about 0.05 g/m²/day at 38° C and 100% relative humidity,
wherein the multilayer barrier film (100) is transmissive to visible and infrared light, and
wherein the protective layer (150) is opaque.

10. The film of claim 9, wherein the protective layer (150; 180) includes a protective sheet (250; 270) and an adhesive (260; 280); and wherein the protective sheet (250; 270) is adjacent to the discrete segments (130; 210, 220) of the multilayer barrier film (100).

11. The film of either claim 9 or claim 10, further comprising:
a pressure sensitive adhesive (120) between the multilayer barrier film (100) and the weatherable sheet (160).

12. The film of claim 11, wherein the pressure sensitive adhesive (120) comprises at least one of a UV stabilizer, a hindered amine light stabilizer, an antioxidant, and a thermal stabilizer.

13. The film of any of claims 9-12, wherein each segment (130) of multilayer barrier film (100) has a first side edge (156) and a second side edge (158), and wherein the continuous multilayer film further comprises:
a protective layer (150) adjacent to at least one of the first and second side edges (156, 158) of the multilayer barrier film (100) to form a continuously edge protected barrier film wherein all edges (156, 158) of the multilayer barrier film (100) are insulated from the environment.

14. The film of any of claims 9-13, wherein the multilayer barrier film (100) has a first major surface and a second major surface and the protective layer (150; 180) is adjacent to the first major surface, further comprising:
a substrate (240) adjacent to the second major surface of the multilayer barrier film (100).

## Patentansprüche

1. Verfahren zum Ausbilden einer durchgehenden Mehrschichtfolie, wobei das Verfahren Folgendes umfasst:
Vorsehen separater Segmente (130; 210, 220) einer Mehrschicht-Barrierefolie (100), wobei benachbarte separate Segmente (130; 210, 220) der Mehrschicht-Barrierefolie durch eine Lücke (140) getrennt sind,
Anbringen einer Schutzschicht (150; 180) angrenzend an zwei benachbarte separate Segmente (130; 210, 220) der Mehrschicht-Barrierefolie (100) derart, dass mindestens ein Abschnitt der Schutzschicht (150; 180) die Lücke (140) überspannt, um eine durchgehende Folie zu bilden, die als Barrierefolie (100) verwendet werden kann, und
Anbringen einer wetterbeständigen Lage (160) angrenzend an die Mehrschicht-Barrierefolie (100),
wobei die Mehrschicht-Barrierefolie (100) eine Wasserdampfübertragungsrate von weniger als etwa 0,05 g/m²/Tag bei 38 °C und 100 % relativer Luftfeuchtigkeit aufweist,
wobei die Mehrschicht-Barrierefolie (100) für sichtbares und infrarotes Licht durchlässig ist, und
wobei die Schutzschicht (150) opak ist.

2. Verfahren nach Anspruch 1, wobei die Schutzschicht (150; 180) eine Schutzlage (250; 270) und einen Klebstoff (260; 280) aufweist, und wobei die Schutzlage (250; 270) an die separaten Segmente (130; 210, 220) der Mehrschicht-Barrierefolie (100) angrenzt.

3. Verfahren nach einem der vorstehenden Ansprüche, welches ferner Folgendes umfasst:
Auftragen eines druckempfindlichen Klebstoffs (120) auf die Mehrschicht-Barrierefolie (100).

4. Verfahren nach Anspruch 3, wobei der druckempfindliche Klebstoff (120) einen UV-Stabilisator, einen gehinderten Amin-Lichtstabilisator, ein Antioxidationsmittel und/oder einen Wärmestabilisator umfasst.

5. Verfahren nach einem der vorstehenden Ansprüche, wobei jedes separate Segment (130; 210, 220) der Mehrschicht-Barrierefolie (100) eine erste Seitenkante (156) und eine zweite Seitenkante (158) aufweist, und wobei das Verfahren ferner Folgendes umfasst:
Anbringen einer Schutzschicht (150; 180) angrenzend an die erste und/oder zweite Seitenkante der separaten Segmente (130; 210, 220) der Mehrschicht-Barrierefolie (100), um eine durchgängige Kantenschutz-Barrierefolie zu bilden, wobei alle Kanten (156,158) der separaten Segmente (130; 210, 220) der Mehrschicht-Barrierefolie (100) von der Umgebung isoliert werden.

6. Verfahren nach einem der vorstehenden Ansprüche, wobei die Mehrschicht-Barrierefolie (100) eine erste Hauptoberfläche und eine zweite Hauptoberfläche aufweist, und wobei die Schutzschicht (150) an die erste Hauptoberfläche angrenzt, wobei das Verfahren ferner Folgendes umfasst:
Anbringen eines Substrats (240) angrenzend an die zweite Hauptoberfläche der Mehrschicht-Barrierefolie (100).

7. Verfahren nach Anspruch 6, wobei das Substrat (240) Polyethylen, Terephthalat, Polyethylennaphthalat, Polyetheretherketon, Polyaryletherketon, Polyacrylat, Polyetherimid, Polyarylsulfon, Polyethersulfon, Polyamidimid und/oder Polyimid umfasst.

8. Verfahren nach einem der vorstehenden Ansprüche, wobei die Mehrschicht-Barrierefolie (100) eine erste Hauptoberfläche und eine zweite Hauptoberfläche aufweist, und wobei die Schutzschicht (150) an die erste Hauptoberfläche angrenzt, wobei das Verfahren ferner Folgendes umfasst:
Anbringen einer elektronischen Vorrichtung angrenzend an die zweite Hauptoberfläche der Mehrschicht-Barrierefolie (100).

9. Durchgehende Mehrschichtfolie, umfassend:
eine wetterbeständige Lage (160),
Segmente (130; 210, 220) einer Mehrschicht-Barrierefolie (100), und
eine Schutzschicht (150; 180), die mindestens einen Abschnitt mindestens zweier benachbarter Segmente (130; 210, 220) der Mehrschicht-Barrierefolie (100) überdeckt,
wobei die durchgehende Mehrschichtfolie als Barrierefolie (100) in einer elektronischen Vorrichtung verwendet werden kann,
wobei die Mehrschicht-Barrierefolie (100) eine Wasserdampfübertragungsrate von weniger als etwa 0,05 g/m²/Tag bei 38 °C und 100 % relativer Luftfeuchtigkeit aufweist,
wobei die Mehrschicht-Barrierefolie (100) für sichtbares und infrarotes Licht durchlässig ist, und
wobei die Schutzschicht (150) undurchsichtig ist.

10. Folie nach Anspruch 9, wobei die Schutzschicht (150; 180) eine Schutzlage (250; 270) und einen Klebstoff (260; 280) aufweist, und wobei die Schutzlage (250; 270) an die separaten Segmente (130; 210, 220) der Mehrschicht-Barrierefolie (100) angrenzt.

11. Folie nach Anspruch 9 oder 10, welche ferner Folgendes umfasst:
einen druckempfindlichen Klebstoff (120) zwischen der Mehrschicht-Barrierefolie (100) und der wetterbeständigen Lage (160).

12. Folie nach Anspruch 11, wobei der druckempfindliche Klebstoff (120) einen UV-Stabilisator, einen gehinderten Amin-Lichtstabilisator, ein Antioxidationsmittel und/oder einen Wärmestabilisator umfasst.

13. Folie nach einem der Ansprüche 9 bis 12, wobei jedes Segment (130) der Mehrschicht-Barrierefolie (100) eine erste Seitenkante (156) und eine zweite Seitenkante (158) aufweist, und wobei die durchgehende Mehrschichtfolie ferner Folgendes umfasst:
eine Schutzschicht (150), die mindestens an die erste und/oder zweite Seitenkante (156, 158) der Mehrschicht-Barrierefolie (100) angrenzt, um eine durchgängige Kantenschutz-Barrierefolie zu bilden, wobei alle Kanten (156, 158) der Mehrschicht-Barrierefolie (100) von der Umgebung isoliert sind.

14. Folie nach einem der Ansprüche 9 bis 13, wobei die Mehrschicht-Barrierefolie (100) eine erste Hauptoberfläche und eine zweite Hauptoberfläche aufweist, und wobei die Schutzschicht (150; 180) an die erste Hauptoberfläche angrenzt, wobei die Folie ferner Folgendes umfasst:
ein Substrat (240), das an die zweite Hauptoberfläche der Mehrschicht-Barrierefolie (100) angrenzt.

## Revendications

1. Procédé de formation d'un film multicouche continu comprenant les étapes consistant à :
fournir des segments discrets (130 ; 210, 220) d'un film barrière multicouche (100), dans lequel des segments discrets adjacents (130 ; 210, 220) du film barrière multicouche sont séparés par un intervalle (140) ;
placer une couche de protection (150 ; 180) adjacente à deux segments discrets adjacents (130 ; 210, 220) du film barrière multicouche (100) de telle sorte qu'au moins une partie de la couche de protection (150 ; 180) couvre l'intervalle (140) pour former un film continu susceptible d'être utilisé comme film barrière (100) ; et
placer une feuille résistante aux intempéries (160) à côté du film barrière multicouche (100),
dans lequel le film barrière multicouche (100) présente un taux de transmission de vapeur d'eau inférieur à environ 0,05 g/m²/jour à 38 °C et 100 % d'humidité relative,
dans lequel le film barrière multicouche (100) laisse passer la lumière visible et infrarouge et
dans lequel la couche de protection (150) est opaque.

2. Procédé selon la revendication 1, dans lequel la couche de protection (150 ; 180) inclut une feuille de protection (250 ; 270) et un adhésif (260 ; 280) ; et dans lequel la feuille de protection (250 ; 270) est adjacente aux segments discrets (130 ; 210, 220) du film barrière multicouche (100).

3. Procédé selon l'une quelconque des revendications précédentes, comprenant en outre l'étape consistant à :
placer un adhésif sensible à la pression (120) sur le film barrière multicouche (100).

4. Procédé selon la revendication 3, dans lequel l'adhésif sensible à la pression (120) comprend au moins un parmi un stabilisant anti-UV, un photostabilisant amine encombrée, un antioxidant, et un stabilisant thermique.

5. Procédé selon l'une quelconque des revendications précédentes, dans lequel chaque segment discret (130 ; 210, 220) du film barrière multicouche (100) présente un premier bord latéral (156) et un deuxième bord latéral (158), et dans lequel le procédé comprend en outre l'étape consistant à :
placer une couche de protection (150 ; 180) adjacente à au moins un des premier et deuxième bords latéraux des segments discrets (130 ; 210, 220) du film barrière multicouche (100) pour former un film barrière à bords protégés en continu dans lequel tous les bords (156, 158) des segments discrets (130 ; 210, 220) du film barrière multicouche (100) sont isolés de l'environnement.

6. Procédé selon l'une quelconque des revendications précédentes, dans lequel le film barrière multicouche (100) possède une première surface principale et une deuxième surface principale et la couche de protection (150) est adjacente à la première surface principale, comprenant en outre l'étape consistant à :
placer un substrat (240) adjacent à la deuxième surface principale du film barrière multicouche (100).

7. Procédé selon la revendication 6, dans lequel le substrat (240) comprend au moins l'un des éléments suivants : polyéthylène téréphtalate, polyéthylène naphtalate, polyétheréthercétone, polyaryléthercétone, polyacrylate, polyétherimide, polyarylsulfone, polyéthersulfone, polyamide-imide ou polyimide.

8. Procédé selon l'une quelconque des revendications précédentes, dans lequel le film barrière multicouche (100) possède une première surface principale et une deuxième surface principale et la couche de protection (150) est adjacente à la première surface principale, comprenant en outre l'étape consistant à :
placer un dispositif électronique adjacent à la deuxième surface principale du film barrière multicouche (100).

9. Film multicouche continu, comprenant :
une feuille résistante aux intempéries (160) ;
des segments (130 ; 210, 220) d'un film barrière multicouche (100) ; et
une couche de protection (150 ; 180) recouvrant au moins une partie d'au moins deux segments adjacents (130 ; 210, 220) du film barrière multicouche (100) ;
dans lequel le film multicouche continu est susceptible d'être utilisé comme un film barrière (100) dans un dispositif électronique,
dans lequel le film barrière multicouche (100) présente un taux de transmission de vapeur d'eau inférieur à environ 0,05 g/m²/jour à 38 °C et 100 % d'humidité relative,
dans lequel le film barrière multicouche (100) laisse passer la lumière visible et infrarouge et
dans lequel la couche de protection (150) est opaque.

10. Film selon la revendication 9, dans lequel la couche de protection (150 ; 180) comprend une feuille de protection (250 ; 270) et un adhésif (260 ; 280) ; et dans lequel la feuille de protection (250 ; 270) est adjacente aux segments discrets (130 ; 210, 220) du film barrière multicouche (100).

11. Film selon la revendication 9 ou la revendication 10, comprenant en outre :
un adhésif sensible à la pression (120) entre le film barrière multicouche (100) et la feuille résistante aux intempéries (160).

12. Film selon la revendication 11, dans lequel l'adhésif sensible à la pression (120) comprend au moins un parmi un stabilisant anti-UV, un photostabilisant amine encombrée, un antioxydant, et un stabilisant thermique.

13. Film selon l'une quelconque des revendications 9 à 12, dans lequel chaque segment (130) du film barrière multicouche (100) présente un premier bord latéral (156) et un deuxième bord latéral (158), et dans lequel le film multicouche continu comprend en outre :
une couche de protection (150) adjacente au moins à un des premier et deuxième bords latéraux (156, 158) du film barrière multicouche (100) pour former un film barrière à bords protégés en continu dans lequel tous les bords (156, 158) du film barrière multicouche (100) sont isolés de l'environnement.

14. Film selon l'une quelconque des revendications 9 à 13, dans lequel le film barrière multicouche (100) possède une première surface principale et une deuxième surface principale et la couche de protection (150 ; 180) est adjacente à la première surface principale, comprenant en outre :
un substrat (240) adjacent à la deuxième surface principale du film barrière multicouche (100).
